# DEMANDE DE BREVET EUROPEEN

(11) **EP 4 156 406 A1**
(43) Date de publication de la demande: **29.03.2023**
(21) Numéro de dépôt: 22197941.2
(22) Date de dépôt: 27.09.2022
(51) Int. Cl.: H01P 3/12, H01P 5/02

(54) **MICROCIRCUIT À GUIDE D'ONDE INTÉGRÉ**

(30) Priorité: 28.09.2021 FR 2110184
(71) Demandeur: Commissariat à l'énergie atomique et aux énergies alternatives, 75015 Paris (FR)
(72) Inventeur: VALORGE, Olivier, 38054 GRENOBLE CEDEX 09 (FR); BELOT, Didier, 38054 GRENOBLE CEDEX 09 (FR); BOUTRY, Hervé, 38054 GRENOBLE CEDEX 09 (FR); DORE, Jean-Baptiste, 38054 GRENOBLE CEDEX 09 (FR); DUBARRY, Christophe, 38054 GRENOBLE CEDEX 09 (FR); FOGLIA MANZILLO, Francesco, 38054 GRENOBLE CEDEX 09 (FR)
(74) Mandataire: Cabinet Camus Lebkiri

(57) **Abrégé**

Microcircuit (100) intégrant un guide d'onde (1) à section rectangulaire, le microcircuit comprenant une première puce (101) et une deuxième puce (102) assemblées l'une sur l'autre, le guide d'onde étant situé dans une zone de jonction (103) entre puces et s'étendant parallèlement aux puces, le guide d'onde comprenant une première plaque (11) conductrice, située du côté de la première puce et parallèle à la première puce, ainsi qu'une deuxième plaque (12) conductrice, située du côté de la deuxième puce et parallèle à la deuxième puce, le guide d'onde étant délimité latéralement, d'un côté et de l'autre du guide, par un ou des éléments de liaison (15) électrique, reliant électriquement la première puce à la deuxième puce.

## Description

### DOMAINE TECHNIQUE

De manière générale, le domaine technique est celui de la micro-électronique, en particulier celui des microcircuits configurés pour émettre, transmettre ou traiter des signaux électriques à des fréquences très élevées, typiquement supérieures à une centaine de GHz.

### ARRIERE-PLAN TECHNOLOGIQUE

Les systèmes de communication sans fil opérant à des fréquences très élevées connaissent actuellement un fort développement, notamment en lien avec le déploiement à venir des systèmes de communication dits « 6G » (sixième génération de technologies de communication sans fil prenant en charge les réseaux de données cellulaires, destinée à succéder à la technologie 5G).

Dans ce contexte, il est souhaitable d'améliorer les performances des dispositifs électroniques, en particulier micro-électroniques, opérant dans cette gamme de fréquence (typiquement entre 0,1 et 2 THz).

Dans un tel circuit électronique, pour transmettre un signal à haute fréquence d'un point à un autre, il est connu d'employer un guide d'onde coplanaire, également appelé ligne coplanaire ou « CPW » (pour « coplanar waveguide », en anglais). Un tel guide d'onde est formé de deux ou trois pistes métalliques parallèles qui s'étendent à la surface d'un même substrat. Mais avec ce type de guide d'onde, de même qu'avec les lignes de type microruban (« microstrip »), les pertes dues à la transmission par le guide sont généralement assez élevées (typiquement supérieures à 3 ou 4 dB par mm parcouru à plusieurs dizaines de GHz). Ces pertes sont causées notamment par des pertes par rayonnement, ainsi que par la présence d'un substrat en silicium au-dessous et/ou au-dessus des lignes de transmission métalliques (substrat qui peut être conducteur, notamment aux interfaces, et induire ainsi des pertes).

Pour guider des signaux à haute fréquence, il est connu aussi d'employer un guide d'onde métallique creux, à section rectangulaire, réalisé sur la face supérieure d'un substrat, la section du guide ayant une largeur d'un ou quelques millimètres, ou d'une fraction de millimètre. Un tel guide est décrit par exemple dans l'article "Monolithic Wafer-Level Rectangular Waveguide and Its Transition to Coplanar Waveguide Line Using a Simplified 3-D Fabrication Process", par N. Vahabisani et M. Daneshmand, IEEE Transactions on Components, Packaging and Manufacturing Technology, vol. 4, no. 1, pp. 168-176, Jan. 2014. Les pertes par transmission avec le guide d'onde décrit dans cet article sont de l'ordre de 1dB (à 70GHz environ) pour une longueur de propagation de 2,6 mm. Elles sont donc plus faibles que pour un guide d'onde à lignes coplanaires. Mais un tel guide augmente l'encombrement du microcircuit et sa fabrication reste relativement complexe.

### RESUME

Dans ce contexte, on propose un microcircuit intégrant un guide d'onde à section rectangulaire, comprenant une première puce et une deuxième puce assemblées l'une sur l'autre, le guide d'onde étant situé dans une zone de jonction entre puces et s'étendant parallèlement aux puces. Le guide d'onde comprend une première plaque conductrice (éventuellement ajourée), située du côté de la première puce et parallèle à la première puce, ainsi qu'une deuxième plaque conductrice (éventuellement ajourée), située du côté de la deuxième puce et parallèle à la deuxième puce, le guide d'onde étant délimité latéralement, d'un côté et de l'autre du guide, par un ou des éléments de liaison électrique, reliant électriquement la première puce à la deuxième puce.

Dans le domaine de la micro-électronique, il est courant d'assembler plusieurs puces les unes sur les autres pour obtenir un microcircuit ayant la structure d'un empilement tridimensionnel. Cela permet par exemple de déporter commodément des connexions électriques, à l'aide d'un interposer comprenant une structure d'interconnexion. Cela permet aussi de combiner des fonctions assez différentes réalisées sur des puces de natures différentes (par exemple réalisées à partir de semi-conducteurs différents). Quoiqu'il en soit, ce type d'assemblage est courant et bien maitrisé en termes de fabrication. L'assemblage de deux puces l'une sur l'autre, avec des connexions électriques entre puces, peut être réalisée par exemple au moyen de micropiliers métalliques, généralement à base de cuivre (technique généralement appelée « Copper Pillar bonding » ou « Copper Pillar Bump ») ou par la technique dite « Direct Hybrid Bonding » (qui sera présentée succinctement plus bas).

Réaliser un tel guide d'onde dans la zone de jonction entre deux puces permet d'exploiter l'espace disponible dans cette zone et d'ajouter de nouvelles fonctionnalités électriques sans encombrement supplémentaire.

Cette zone de jonction a par ailleurs une géométrie propice à la réalisation d'un tel guide : les faces respectives des deux puces, situées en vis-à-vis l'une de l'autre, forment chacune un support bien adapté pour les première et deuxièmes plaques en question (qui délimitent le guide verticalement), tandis que les bordures latérales du guide sont formées d'éléments de liaison entre puces (tels que des micropiliers par exemple) dont la réalisation, sans une telle zone de jonction, est bien maitrisée.

Dans la présente demande, on entend par puce une structure globalement plane (dont la forme d'ensemble est celle d'une petite plaque), à base d'un ou plusieurs matériaux semi-conducteurs (ainsi que d'autres matériaux, en particulier des matériaux métalliques et/ou des oxydes isolant électriquement), et pouvant intégrer différents composants, actifs ou passifs (transistor, diode, résistance, structure rayonnante ou de guidage). La puce en question peut être formée par un wafer complet (et fonctionnalisé), ou par une portion seulement d'un tel wafer (c'est-à-dire par un Die).

Ce type de solution est particulièrement intéressant pour guider des ondes électromagnétiques à très hautes fréquences (notamment dans la gamme allant de 0,1 et 2 THz, adaptée aux futures applications de télécommunication « 6G »), car les longueurs d'onde correspondantes sont alors petites (quelques mm, à quelques fractions de mm), ce qui permet de réaliser un guide peu encombrant, adapté à un microcircuit.

Les éléments de liaison électrique mentionné plus haut peuvent par exemple être des éléments de contactage, tels que des micropiliers ou des microbilles, électriquement conducteurs, permettant chacun une conduction électrique de la première plaque à la deuxième plaque. En d'autres termes, ces éléments de liaison peuvent former chacun un pont conducteur entre la première plaque et la deuxième plaque, en permettant le passage d'un courant électrique, par conduction, d'une plaque à l'autre.

Les éléments de liaison électrique peuvent aussi être des éléments qui relient la première plaque à la deuxième plaque par une liaison capacitive (sans contact électrique direct). Dans ce cas, chaque élément de liaison comprend :
- soit un micropoteau, qui s'étend depuis l'une des deux plaques, en direction de l'autre plaque, jusqu'à une distance réduite de cette autre plaque (pour obtenir un effet capacitif entre une face d'extrémité du micropoteau et cette autre plaque),
- soit un premier et un deuxième micropoteaux qui se raccordent respectivement à la première plaque et à la deuxième plaque et qui s'étendent en vis-à-vis l'un de l'autre, mais sans contact électrique entre ces deux micropoteaux.

Dans le deuxième cas (avec deux micropoteaux situés en vis-à-vis l'un de l'autre, le couplage capacitif peut etre optimisé en rajoutant une pastille metallique sur la face d'extremité de chacun des premier et deuxieme micropoteaux. Ces pastilles sont par exemple imprimés sur le substrat diélectrique entre les deux rangées de micropoteaux et sont dimensionnés pour minimiser les pertes de transmission du guide.

Outre les caractéristiques présentées ci-dessus, le dispositif présenté ci-dessus peut présenter une ou plusieurs des caractéristiques optionnelles suivantes, considérées individuellement ou selon toutes les combinaisons techniquement envisageables :
- les éléments de liaison électrique comprennent des micropoteaux ou des micropiliers ou des microbilles disposés en ligne les uns à la suite des autres, le long du côté considéré du guide d'onde ;
- lesdits micropoteaux ou micropiliers ou microbilles sont répartis le long du côté considéré du guide d'onde avec un taux d'occupation linéïque supérieur à 50% ;
- la première plaque est recouverte d'une première couche électriquement isolante traversée par des premiers vias conducteurs, la deuxième plaque est recouverte d'une deuxième couche électriquement isolante traversée par des deuxièmes vias conducteurs, la deuxième couche est en contact (généralement directement en contact) avec la première couche et adhère à la première couche, les deuxièmes vias étant en contact avec les premiers vias, directement ou par l'intermédiaire d'éléments de raccordement, chaque élément de liaison comprenant l'un des premiers vias, ainsi que le deuxième via correspondant avec lequel il est en contact ;

- au moins certains desdits éléments de liaison sont des éléments de contactage électriquement conducteur, permettant chacun une conduction électrique de la première plaque à la deuxième plaque ;
- au moins l'un desdits éléments de liaison comprend un micropoteau électriquement conducteur qui s'étend à partir de la première plaque en direction de la deuxième plaque, et qui est espacé de la deuxième plaque, pour relier la première plaque à la deuxième plaque par une liaison capacitive ;
- ledit élément de liaison, qui relie la première plaque à la deuxième plaque par une liaison capacitive, comprend un micropoteau supplémentaire électriquement conducteur, qui s'étend à partir de la deuxième plaque, en direction de la première plaque, jusqu'à une face d'extrémité du micropoteau supplémentaire, la face d'extrémité du micropoteau supplémentaire étant située en vis-à-vis et à distance réduite d'une face d'extrémité dudit micropoteau ; en alternative, on peut prévoir que ledit micropoteau s'étende depuis la première plaque jusqu'à une face d'extrémité du micropoteau située en vis-à-vis et à distance réduite de la deuxième plaque (plutôt qu'en vis-à-vis d'un micropoteau supplémentaire).
- le guide d'onde est dimensionné pour guider une onde électromagnétique ayant une fréquence f supérieure ou égale à 100 GHz ;
- l'espace intérieur du guide, situé entre les première et deuxième plaques et entre lesdits éléments de liaison, est occupé par un milieu diélectrique ayant une permittivité relative εr à la fréquence f, et dans lequel le guide d'onde a une section dont la largeur, selon une direction parallèle aux puces, est supérieure à λ/2, où λ=c/(f.(εᵣ)^{1/2}), c étant la vitesse des ondes électromagnétiques dans le vide ;
- l'espace intérieur du guide, situé entre les première et deuxième plaques et entre lesdits éléments de liaison, est occupé par une structure composite formée de plusieurs matériaux diélectriques différents ;
- l'une au moins des première et deuxième puces intègre un ou plusieurs composants de type transistor, diode ou amplificateur, configuré pour générer, amplifier ou filtrer un signal électrique de fréquence supérieure ou égale à 100 GHz ;
- une extrémité du guide est ouverte et une partie au moins du guide, qui débouche par cette ouverture, est évasée et s'élargit en direction de ladite ouverture ; en d'autres termes, au niveau de cette partie évasée, chaque section du guide section a une largeur qui est d'autant plus grande que la section est proche de l'ouverture de sortie du guide ;
- le guide présente un ou plusieurs changements de section abrupts (c'est-à-dire avec une discontinuité de section, par exemple un changement de largeur, avec un saut, d'une première largeur à une deuxième largeur différente) ;
- le guide d'onde comprend un éléments de liaison supplémentaires, situés chacun à l'intérieur du guide ; ce ou ces éléments de liaison supplémentaires sont répartis à l'intérieur du guide, par exemple selon une distribution spécifique d'une fonction (par exemple de filtrage) à réaliser par le guide ;
- ces éléments de liaison supplémentaires sont répartis en une ou plusieurs lignes d'éléments de liaison supplémentaires, qui s'étendent chacune transversalement par rapport au guide, à l'intérieur du guide, pour former un étranglement dans le guide ;
- le guide d'onde comprend un ou plusieurs lignes micropoteaux internes, situés chacun à l'intérieur du guide, chaque micropoteau interne s'étendant à partir de la première plaque, en direction de la deuxième plaque, et ayant une hauteur inférieure à un écart qui sépare la première plaque de la deuxième plaque, par exemple inférieure aux deux tiers dudit écart ; le ou les micropoteaux internes sont répartis à l'intérieur du guide, par exemple selon une distribution spécifique d'une fonction (par exemple de filtrage) à réaliser par le guide ;
- en particulier, le ou les micropoteaux internes peuvent être répartis en une ou plusieurs lignes de micropoteaux internes, qui s'étendent chacune transversalement par rapport au guide, à l'intérieur du guide.

La présente technologie et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif.
[Fig. 1] La figure 1 représente schématiquement un microcircuit comprenant deux puces assemblées l'une sur l'autre et comprenant un guide d'onde situé dans une zone d'assemblage, entre ces deux puces, vu de côté.
[Fig. 2] La figure 2 représente schématiquement et partiellement le guide d'onde de la figure 1, en perspective.
[Fig. 3] La figure 3 montre l'évolution d'un coefficient de transmission du guide d'onde de la figure 2, en fonction de la fréquence de l'onde guidée.
[Fig. 4] La figure 4 représente schématiquement une variante du guide de la figure 2, vue de côté.
[Fig. 5] La figure 5 représente schématiquement, vu de dessus, un deuxième mode de réalisation d'un guide d'onde pouvant équiper le microcircuit de la figure 1, à la place ou en complément du guide d'onde de la figure 2.
[Fig. 6] La figure 6 représente schématiquement le guide d'onde de la figure 5, vu de côté.
[Fig. 7] La figure 7 représente schématiquement, vu de dessus, un troisième mode de réalisation d'un guide d'onde pouvant équiper le microcircuit de la figure 1, à la place ou en complément du guide d'onde de la figure 2.
[Fig. 8] La figure 8 représente schématiquement le guide d'onde de la figure 7, vu de côté.
[Fig. 9] La figure 9 représente schématiquement, vu de dessus, un quatrième mode de réalisation d'un guide d'onde pouvant équiper le microcircuit de la figure 1, à la place ou en complément du guide d'onde de la figure 2.
[Fig. 10] La figure 10 représente schématiquement le guide d'onde de la figure 9, vu de côté.
[Fig. 11] La figure 11 représente schématiquement une variante du guide d'onde de la figure 9, vu de dessus.
Fig. 12] La figure 12 représente schématiquement le guide d'onde de la figure 11, vu de face, en coupe.
[Fig. 13] La figure 13 représente schématiquement un microcircuit selon un autre mode de réalisation, comprenant deux puces assemblées l'une sur l'autre et comprenant un guide d'onde située dans une zone d'assemblage, entre ces deux puces, vu de côté.
[Fig. 14] La figure 14 représente schématiquement encore un autre mode de réalisation d'un guide d'onde, pouvant par exemple équiper le microcircuit de la figure 1, à la place ou en complément du guide d'onde de la figure 2.

### DESCRIPTION DETAILLEE

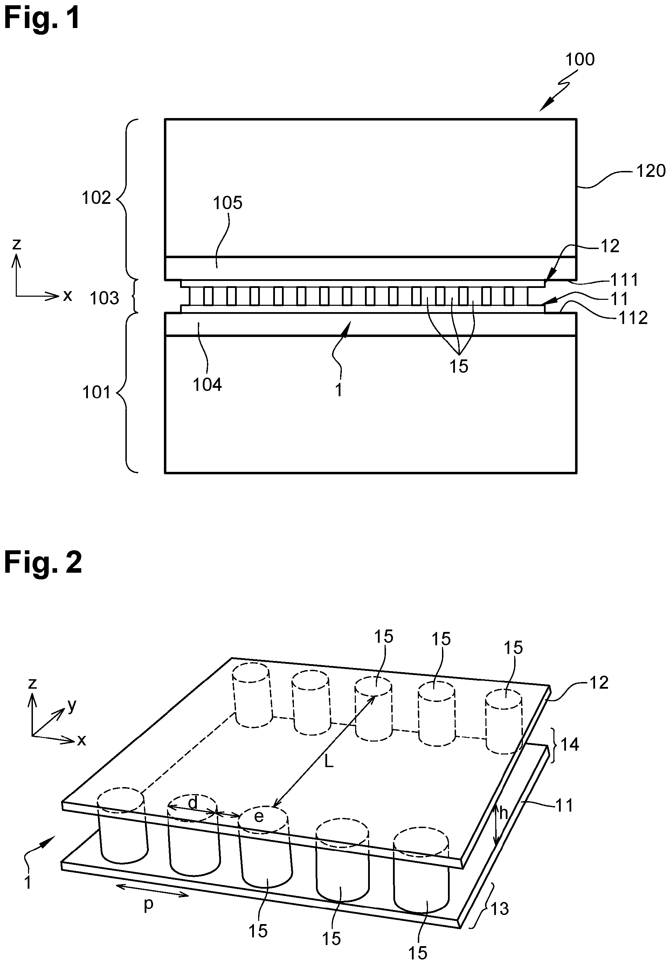

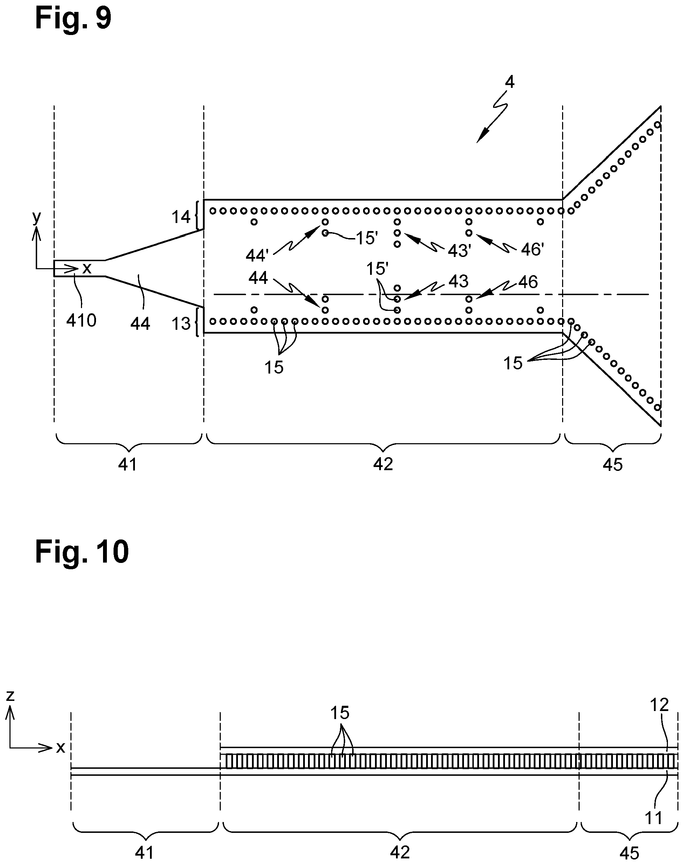

Comme indiqué ci-dessus dans la partie « résumé », la présente technologie concerne un microcircuit intégrant un guide d'onde à section rectangulaire, ce guide étant réalisé dans une zone de jonction entre une première puce (puce inférieure) et une deuxième puce (puce supérieure) du microcircuit (voir les figures 1 et 10). Le guide d'onde est délimité latéralement par des éléments de liaison électrique reliant électriquement la première puce à la deuxième puce (microbilles, micropiliers, ou vias, par exemple), électriquement conducteurs.

La figure 1 représente schématiquement un tel microcircuit 100, dans lequel les première et deuxième puces 101 et 102 sont assemblées au moyen de micropiliers. Pour ce mode de réalisation, les éléments de liaison entre puces, qui délimitent latéralement le guide d'onde, 1, de ce microcircuit 100, sont des micropiliers 15.

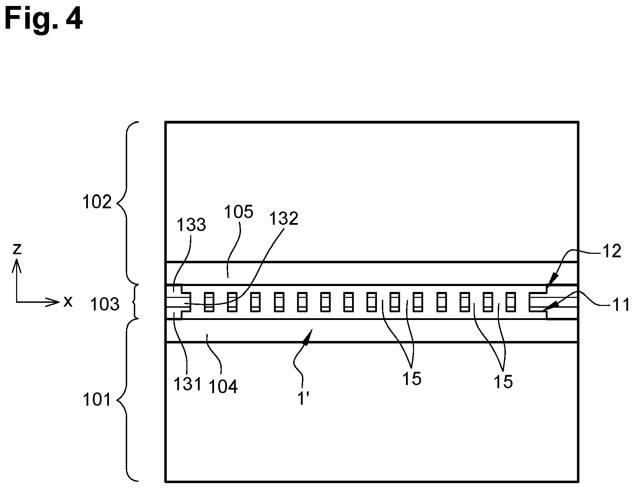

La figure 2 représente schématiquement le guide d'onde 1 de ce premier mode de réalisation, partiellement, en perspective. La figure 4 représente schématiquement une variante de premier mode de réalisation (dans laquelle l'espace interne du guide est occupé par différents matériaux diélectriques, au lieu d'un même milieu diélectrique homogène).

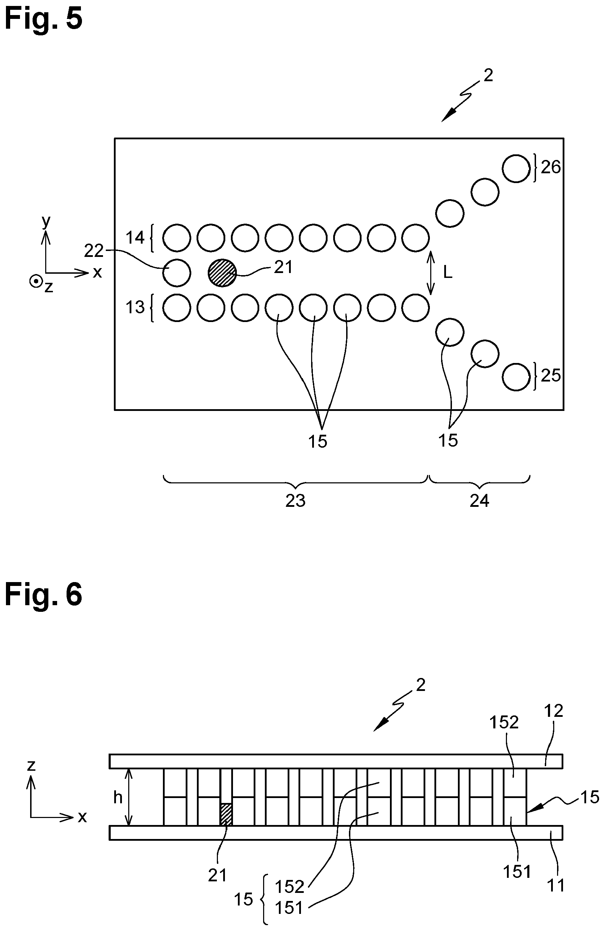

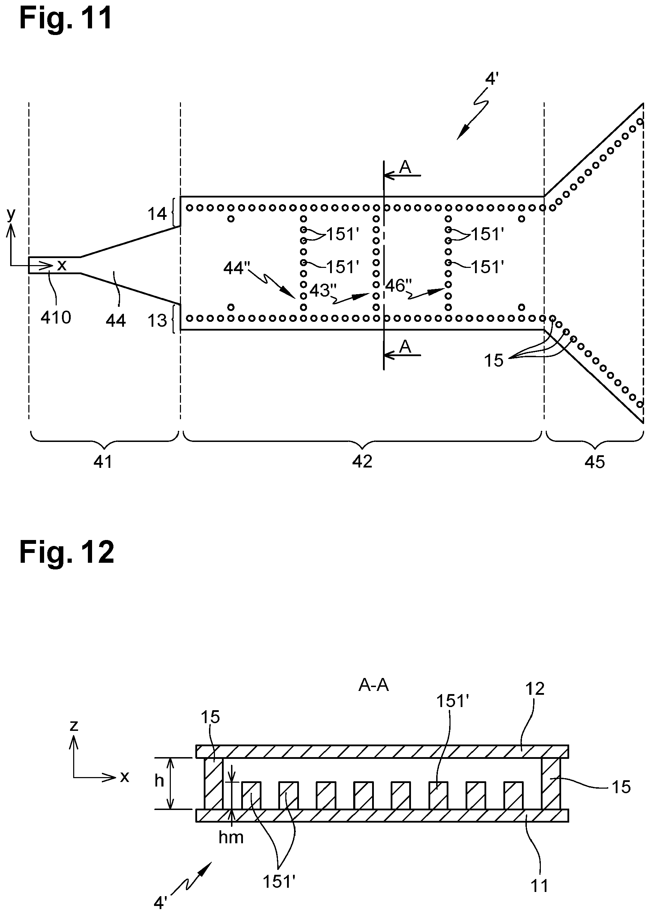

Les figures 5, 7 et 9 représentent quant à elles un deuxième, troisième et quatrième mode de réalisation d'un guide d'onde 2 ; 3 ; 4, qui pourrait équiper le microcircuit 100 de la figure 1, à la place ou en complément du guide d'onde 1. Le guide d'onde 2 ; 3 ; 4 selon ces deuxième, troisième et quatrième modes de réalisation est délimité lui aussi, latéralement, par des micropiliers 15. La figure 11 représente schématiquement une variante du quatrième mode de réalisation.

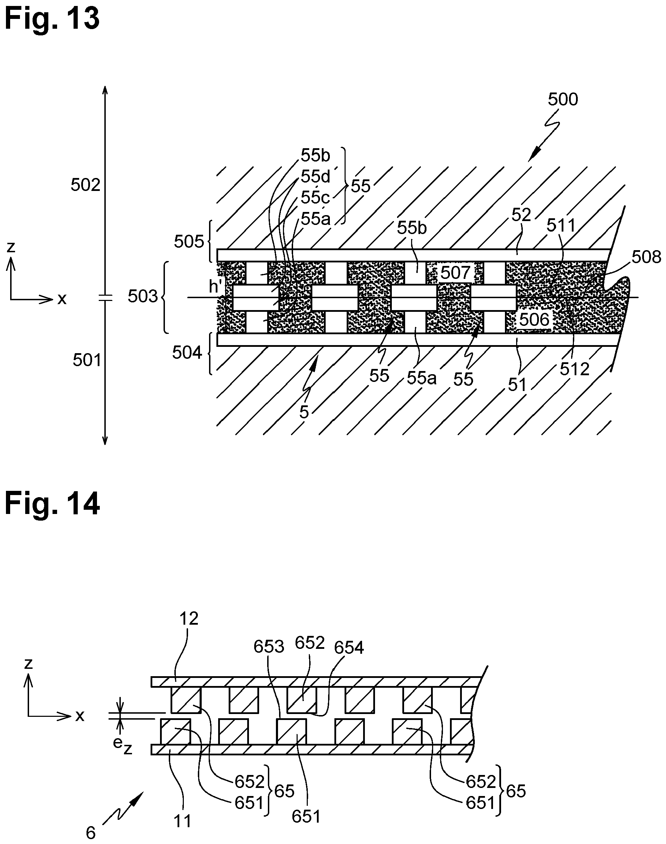

La figure 13 représente quant à elle un cinquième mode de réalisation d'un guide d'onde, 5, réalisé dans une zone d'assemblage entre puces. Pour ce mode de réalisation, les deux puces sont assemblées par « liaison hybride directe » (« Direct Hybrid Bonding », en anglais), au lieu d'être assemblées par une technique de micropiliers. Les éléments de liaison 55, qui délimitent latéralement le guide 5, comprennent alors des vias 55a, 55b, qui traversent deux couches isolantes 506 et 507 mises en contact l'une avec l'autre, au niveau d'une surface d'assemblage 508, pour lier entre elles les deux puces 501 et 502.

La figure 14 représente schématiquement un sixième mode de réalisation d'un guide d'onde, 6, réalisé dans une zone d'assemblage entre puces. Dans ce mode de réalisation, les puces sont assemblées au moyen de micropiliers (comme pour les modes de réalisation 1 à 4). En revanche, les éléments de liaison qui délimitent latéralement le guide sont alors formés chacun de deux micropoteaux (l'un raccordé à la première puce, et l'autre raccordé à la deuxième puce) situés en vis-à-vis l'un de l'autre, mais sans contact électrique entre eux (les deux micropoteaux établissant une liaison électrique capacitive entre les puces au lieu d'une liaison « conductive »).

Dans la suite, on présentera d'abord succinctement les deux techniques d'assemblages en question (par micropiliers, et par liaison hybride directe).

Des aspects communs aux six modes de réalisation du guide d'onde 1 ; 2 ; 3 ; 4 ; 5 ; 6 (et de leurs variantes 1' et 4') seront présentés ensuite (largeur du guide et taux d'occupation des éléments de liaison le long du guide, par exemple).

Enfin, ces six modes de réalisation du guide (et leurs variantes 1' et 4') seront présentés chacun plus en détail.

D'un mode de réalisation à l'autre, les éléments identiques ou correspondant seront repérés autant que possible par les mêmes numéros de référence.

### Puces du microcircuit

Quel que soit le mode de réalisation, le microcircuit 100 ; 500 comprend la première puce 101 ; 501, et la deuxième puce 102 ; 502 mentionnées plus haut (voir les figures 1 et 13).

Ici, l'une au moins des deux puces, et même les deux, est fonctionnalisée, en ce sens qu'elle intègre des composants (dont des composants actifs), notamment de type transistor, diode ou amplificateur (non représentés). L'un au moins de ces composants est configuré pour générer, émettre, amplifier ou filtrer un signal électrique de fréquence f supérieure ou égale à 100 GHz, voire supérieure ou égale à 300 GHz.

Ici, la première puce 101 ; 501 est à base de silicium, et la deuxième puce 102 ; 502 est à base d'Arsenure de Gallium GaAs par exemple (plus généralement, à base d'un semiconducteur de type III-V, c'est-à-dire comprenant un élément de la colonne V du tableau périodique des éléments, par exemple de l'azote N ou du phosphore P, associé à un ou plusieurs éléments de la colonne III du tableau périodique des éléments, par exemple du gallium Ga, de l'aluminium Al et/ou de l'indium In). La première puce 101 ; 501, à base de silicium, constitue un support bien adapté pour réaliser un ou des composants permettant une montée en fréquence des signaux, et permettant de générer un signal à très haute fréquence, mais de puissance généralement limitée. Elle peut par exemple comprendre différents composants de type CMOS, dont un préamplificateur (qui délivre un signal à la fréquence f mentionnée plus haut). Quant à la deuxième puce 102 ; 502, elle constitue un support bien adapté pour réaliser un ou des composants permettant une amplification de puissance à ces fréquences très élevées.

On notera toutefois que les première et deuxième puces pourraient, en variante, être formée à partir de matériaux semi-conducteurs différents de ceux mentionnés ci-dessus ; en particulier, elles pourraient toutes deux être formées à partir du même type de matériau semi-conducteur (par exemple du silicium).

La première puce 101 ; 501 et la deuxième puce 102 ; 502 sont assemblées l'une sur l'autre, parallèlement entre elles, pour former un empilement tridimensionnel. Ces deux puces sont assemblées l'une sur l'autre en ce sens qu'elles sont liées mécaniquement l'une à l'autre, avec la deuxième puce 102 ; 502 située au-dessus de la première puce 101 ; 501, parallèlement à celle-ci, quasiment contre la première puce 101 ; 501. En pratique, la liaison mécanique entre puces est obtenue en faisant adhérer des éléments superficiels 151 ; 55c de la première puce 101 ; 501, avec des éléments superficiels 152 ; 55d de la deuxième puce 102 ; 502. La première puce 101 ; 501 présente une première surface 111 ; 511, la deuxième puce 102 ; 502 présente une deuxième surface 112 ; 512, et les deux puces sont assemblées de manière à ce que la première surface 111 ; 511 s'étende en vis-à-vis de la deuxième surface 112 ; 512, parallèlement et à distance réduite de la deuxième surface, voire directement en contact avec cette deuxième surface (dans le cas d'un assemblage de type « Direct Hybrid Bonding », tel que celui de la figure 13).

Les deux puces peuvent être reliées électriquement l'une à l'autre, par des connections électriques (qui traversent la zone d'assemblage) ne faisant pas partie du guide, non représentées.

### Assemblage par micropiliers

Dans le cas d'un assemblage par une technique de type micropiliers, qui est le cas du microcircuit 100 de la figure 1, chaque micropilier 15 comprend typiquement deux micropoteaux 151, 152, conducteurs (voir la figure 6, à titre de complément), souvent appelés « post » en anglais, l'un réalisé sur la première puce, et l'autre sur la deuxième puce, raccordés l'un à l'autre, par exemple par une microbille de soudure (formée à partir d'un matériau à base d'étain, ou d'indium). Chaque micropoteau 151, 152 forme ainsi un demi-micropilier. Un tel micropilier 15 a par exemple une hauteur totale comprise entre 5 et 50 microns. La première surface 111 mentionnée plus haut est alors une surface libre que présente la première puce 101 avant assemblage (il s'agit par exemple sa surface libre supérieure), micropiliers et autres éléments d'assemblage mis à part. De même, la deuxième surface 112 est alors une surface libre présentée par la deuxième puce 102 avant assemblage (par exemple sa surface libre inférieure), micropiliers et autres éléments d'assemblage mis à part. La zone d'assemblage 103, où est situé le guide d'onde 1, s'étend entre cette première surface 111 et cette deuxième surface 112 (et éventuellement légèrement au-delà, par exemple jusqu'à une couche de métallisation de chaque puce), avec une épaisseur typiquement inférieure à 100 microns.

Lors de l'assemblage, on place la deuxième puce 102 en vis-à-vis de la première puce 101, avec ses micropoteaux 152 en face des micropoteaux 151 correspondants de la première puce 101, et on approche les deux puces l'une de l'autre pour mettre en contact ces micropoteaux entre eux (ce contact pouvant se faire par l'intermédiaire d'une microbille de soudure). Un matériau de remplissage optionnel (généralement appelé « underfill »), par exemple un polymère, peut être introduit ensuite dans la zone d'assemblage 103 pour remplir la partie inoccupée de cette zone (afin d'obtenir un assemblage plus robuste mécaniquement et thermiquement, en formant une couche de liaison entre puces).

On notera que, de manière générale, dans la présente demande, on désigne par « micropoteau » un élément, par exemple de forme cylindrique, faisant saillie par rapport à la puce considérée, en s'étendant en direction de l'autre puce mais pas totalement jusqu'à l'autre puce. Les dimensions (diamètre, hauteur) d'un tel micropoteau sont typiquement supérieures à 10 microns, et inférieures à 50 microns. Et par « micropilier », ou, de manière équivalente, par « micropilier complet » on désigne un élément qui s'étend depuis l'une des deux puces jusqu'à l'autre puce, en raccordant ces deux puces entre elles. Un tel micropilier est par exemple formé de deux micropoteaux, l'un réalisé sur la première puce, et l'autre sur la deuxième puce, raccordés l'un à l'autre par une microbille de soudure. Les micropoteaux et les micropiliers en question sont électriquement conducteurs. Ils sont typiquement formés d'un ou plusieurs matériaux métalliques. Chaque micropoteau 151, 152 peut être d'un seul tenant, formé d'un même matériau métallique (par exemple du cuivre ou un alliage à base de cuivre), ou comprendre plusieurs portions (plusieurs couches) formées de matériaux métalliques différents.

Dans le cas des guides d'onde 1 ; 1' ; 2 ; 3 ; 4 et 4', les éléments de liaison électrique, qui délimitent latéralement le guide, sont formés chacun par un de ces éléments d'assemblage, donc par un micropilier complet 15, entièrement conducteur (qui met en contact électrique la première puce avec la deuxième puce, via une liaison « conductive »).

Dans le cas du guide d'onde 6 de la figure 14, les première et deuxième puces sont assemblées l'une à l'autre par des micropiliers complets tels que décrits ci-dessus (micropiliers « d'assemblage » qui ne sont pas représentés sur la figure 14). Mais les éléments de liaison électrique 65, qui délimitent latéralement le guide 6, ne sont pas ces éléments d'assemblage eux-mêmes, dans ce cas. Dans ce mode de réalisation, les éléments de liaison 65 comprenant chacun deux micropoteaux 651, 652 situés en vis-à-vis l'un de l'autre, mais sans contact entre ces deux micropoteaux 651, 652 (un mince intervalle étant présent entre les faces d'extrémité 653, 654 respectives de ces micropoteaux 651, 652), ces deux micropoteaux assurant une liaison capacitive entre les puces.

La première puce 101 comprend par ailleurs, du côté de la première surface 111, par exemple juste sous cette surface, un ou des niveaux métalliques 104 (plans de métallisation), qui peuvent par exemple comprendre des pistes d'interconnexion.

Le guide d'onde 1 ; 1' ; 2 ; 3 ; 4 ; 4' ; 6 comprend une première plaque conductrice, 11, parallèle aux puces, située du côté de la première puce 101 (cette plaque délimite le guide d'onde 1 ; 1' ; 2 ; 3 ; 4 ; 4' ; 6 en partie inférieure). Cette première plaque 11 peut être formée sur la première surface 111, ou légèrement en retrait par rapport à celle-ci. Elle peut être formée dans le niveau métallique, ou dans l'un des niveaux métalliques 104 mentionnés ci-dessus.

De même, la deuxième puce 102 comprend, du côté de la deuxième surface 112, par exemple juste au-dessus de cette surface, un ou des niveaux métalliques 105 (plans de métallisation), qui peuvent par exemple comprendre des pistes d'interconnexion. Le guide d'onde 1 ; 1' ; 2 ; 3 ; 4 ; 4' ; 6 comprend une deuxième plaque conductrice, 12, parallèle aux puces, située du côté de la deuxième puce 102 (cette plaque délimite le guide d'onde 1 ; 1' ; 2 ; 3 ; 4 ; 4' ; 6 en partie supérieure, ici). Cette deuxième plaque 12 peut être formée sur la deuxième surface 112, ou légèrement en retrait par rapport à celle-ci. Elle peut être formée dans le niveau métallique, ou dans l'un des niveaux métalliques 105 en question.

### Assemblage par « liaison hybride directe »

Dans le cas d'un assemblage de type « Direct Hybrid Bonding », qui est le cas du microcircuit 500 de la figure 13, chaque puce 501, 502 présente, avant assemblage, une couche isolante superficielle 506, 507, par exemple en oxyde de silicium SiO₂, traversée par des vias conducteurs, 55a, 55b (en général métalliques, par exemple à base de cuivre, et parfois appelés « hybrid bonding via »). De manière optionnelle, chaque via 55a, 55b peut se raccorder à un élément de raccordement 55c, 55d conducteur, du côté d'une surface libre 511, 512 de cette couche isolante 506, 507. Cet élément de raccordement 55c, 55d, qui a par exemple la forme d'une petite plaquette métallique, ou encore « hybrid bonding metal »), a une section plus grande que celle du via 55a, 55b lui-même (l'élément 55c est plus large que le via 55a), pour permettre un meilleur contact électrique entre puces. Le via lui-même, ou, ici, l'élément de raccordement en question 55c, 55d, affleure au niveau de la surface libre 511, 512 de cette couche isolante 506, 507. Cette surface libre 511, 512, avec les vias ou éléments de raccordement 55c, 55d qui affleurent, est obtenue par planarisation, par exemple de type mécano-chimique (ou CMP, pour « Chemical-mechanical polishing » en anglais). Il s'agit de la surface libre de la puce considérée, 501 ou 502, avant assemblage. La première surface 511 mentionnée plus haut est formée par cette surface libre de la première puce 501, tandis que la deuxième surface 512 est formée par la surface libre de la deuxième puce 502. Les deux puces 501 et 502 sont assemblées en mettant en contact la première surface 511 et la deuxième surface 512 l'une contre l'autre, après avoir aligné latéralement les deux puces l'une par rapport à l'autre de manière à positionner les éléments de raccordement de la première puce, 55c, en face de ceux, 55d, de la deuxième puce (ou, en l'absence de tels éléments, de manière à positionner les vias de la première puce en face de ceux de la deuxième puce). Après assemblage, les deux surfaces 511 et 512 sont confondues, formant une même surface d'assemblage 508.

La première puce 501 comprend un niveau métallique 504 (couche de métallisation souvent appelée couche « MZ »), située sous la couche isolante 506, par exemple immédiatement en dessous de la couche isolante 506.

Le guide d'onde 5 comprend une première plaque conductrice, 51, parallèle aux puces, située du côté de la première puce 501 (cette plaque, qui appartient à la première puce, délimite le guide d'onde 1 ; 2 ; 3 ; 4 en partie inférieure). Cette première plaque 51 peut être formée, comme ici, dans le niveau métallique 504. Les vias 55a s'étendent chacun à travers la couche isolante 506, et jusqu'à cette première plaque 51 à laquelle ils se raccordent.

De la même manière, la deuxième puce 502 comprend un niveau métallique 505 (couche de métallisation « MZ »), située au-dessus, par exemple immédiatement au-dessus de la couche isolante 507. Et le guide d'onde 5 comprend une deuxième plaque conductrice, 52, parallèle aux puces, située du côté de la deuxième puce 502 (cette plaque, qui fait partie de la deuxième puce, délimite le guide d'onde 5 en partie supérieure, ici). Cette deuxième plaque 52 peut être formée, comme ici, dans le niveau métallique 505. Les vias 55b s'étendent chacun à travers la couche isolante 507, et jusqu'à cette deuxième plaque 52 à laquelle ils se raccordent.

Par « via » on entend ici un élément conducteur, généralement métallique, qui traverse une couche isolante et permettant les connexions mécanique et électrique de deux éléments métalliques de part et d'autre de cette couche isolante. Un tel via peut avoir une forme globalement cylindrique, ou une forme de paroi plane perpendiculaire aux puces (notamment lorsque le via est obtenu en remplissant une tranchée gravée dans la couche isolante en question). Un tel via peut être obtenu en ouvrant une tranchée ou un trou dans la couche isolante, puis en remplissant la tranchée ou le trou par un matériau conducteur. De tels vias peuvent aussi être obtenus en formant tout d'abord ces éléments conducteurs individuels sur une face de la puce (par croissance, ou par gravure), puis en les recouvrant par une couche isolante (en SiO₂) qui est ensuite planarisée.

De manière optionnelle, les vias en question peuvent se prolonger, dans la puce correspondante, au-delà de la couche isolante 506, 507, par exemple à travers une couche de silicium, ou se raccorder à d'autres vias (de type « Through Silicium Via ») traversant une telle couche de silicium.

Dans le cas d'un tel assemblage par « liaison hybride directe », les éléments de liaison mentionnés plus haut, 55, comprennent chacun un via 55a et le via 55b correspondant (i.e. : celui qui est en contact avec ce via 55a). Les éléments de liaison 55 peuvent aussi comprendre chacun plusieurs vias 55a, en contact avec plusieurs vias 55b. Le contact en question peut être un contact direct, ou , comme ici, un contact par l'intermédiaire des éléments de raccordement 55c et 55d mentionnés plus haut, ces éléments de raccordement faisant alors partie eux aussi de l'élément de liaison 55.

Pour ce type d'assemblage, la zone d'assemblage 503 est une zone qui s'étend de part et d'autre de la surface d'assemblage 508. Elle s'étend par exemple, d'un côté, jusqu'au un plan de métallisation 504 de la première puce 501, et de l'autre, jusqu'au plan de métallisation 505 de la deuxième puce 502. Cette zone d'assemblage 503 a une épaisseur comprise par exemple entre 1 et 10 microns.

### Propriétés communes des guides d'onde

Quel que soit le mode de réalisation, le guide d'onde 1 ; 1' ; 2 ; 3 ; 4 ; 4' ; 5 ; 6 s'étend parallèlement aux puces. Trois axes perpendiculaires entre eux, x, y et z, sont introduits pour faciliter la description du guide. L'axe z est perpendiculaire aux puces. L'axe x est un axe longitudinal moyen du guide. C'est l'axe le long duquel s'étend le guide (il s'agit de la direction de propagation des ondes guidées dans le guide). L'axe y est un axe transverse par rapport au guide, et parallèle aux puces.

Le guide d'onde 1 ; 1' ; 2 ; 3 ; 4 ; 4' ; 5 ; 6 comprend les éléments suivants, électriquement conducteurs, qui permettent de guider des ondes électromagnétiques à l'intérieur du guide :
- la première plaque 11 ; 51 mentionnée ci-dessus (en partie inférieure du guide),
- la deuxième plaque 12 ; 52 (en partie supérieure du guide, et qui est parallèle à la première plaque), et
- d'un côté et de l'autre du guide, les éléments de liaison 15 ; 55 ; 65, qui délimitent latéralement le guide 1 ; 1' ; 2 ; 3 ; 4 ; 4' ; 5 ; 6 et qui relient les première et deuxième plaques l'une à l'autre.

Le guide est délimité latéralement
- d'un côté, par une première ligne d'éléments de liaison 15 ; 55 ; 65 disposés les uns à la suite des autres, et
- de l'autre par une deuxième ligne d'éléments de liaison 15 ; 55 ; 65 également disposés les uns à la suite des autres (voir les figures 2, 5 et 9 par exemple).

Pour le guide d'onde 1, les première et deuxième lignes d'éléments de liaison, qui portent respectivement les références 13 et 14, sont rectilignes et parallèles entre elles. C'est le cas aussi pour les portions 23 ; 35 et 42 des guides d'ondes 2 ; 3 et 4 (figures 5, 7, 9), portions le long desquelles la section du guide est constante. On notera que, dans la présente demande, le terme « section » désigne une section transverse, c'est-à-dire une coupe du guide d'onde (selon un plan de coupe transverse, parallèle au plan (y,z)), et non un tronçon ou une portion de ce guide.

Pour certaines parties du guide, les première et deuxième lignes peuvent ne pas être parallèles entre elles, et former un certain angle d'ouverture entre elles. C'est le cas par exemple pour les portions 24 et 45 du guide 2 et 4, qui forment des portions évasées, à la manière d'une antenne de type cornet.

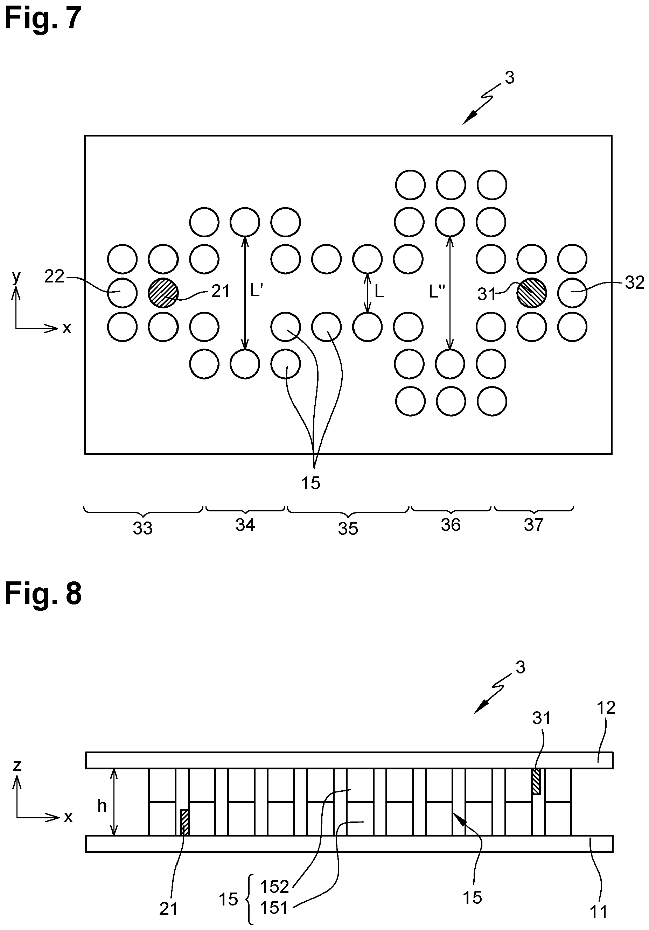

Par ailleurs, ces première et deuxième lignes ne sont pas forcément des lignes continues, ou rectilignes ; il peut en particulier s'agir d'une succession de lignes brisées (voir le guide 3 de la figure 7 par exemple).

Le guide d'onde 1 ; 1' ; 2 ; 3 ; 4 ; 4' ; 5 ; 6 a une section rectangulaire en ce sens que, pour chaque section transverse du guide, la zone intérieure du guide est délimitée par un contour rectangulaire (plaque 11, plaque 12, et éléments de liaison gauche et droit), sauf si la section en question tombe entre deux éléments de liaison successifs, et erreurs d'alignement entre puces mises à part. Les modes de propagation dans ce guide sont de type Transverse Electrique (TE) et plus précisément TEₙ₀, où *n* est un nombre naturel). La propagation de ces modes dans ledit guide est comparable à la propagation qui serait obtenue dans un guide équivalent de section rectangulaire délimité par quatre plaques planes pleines (voir par exemple l'article : D. Deslandes and Ke Wu, "Accurate modeling, wave mechanisms, and design considérations of a substrate integrated waveguide," in IEEE Transactions on Microwave Theory and Techniques, vol. 54, no. 6, pp. 2516-2526, June 2006).

Dans les six modes de réalisation représentés, le guide 1 ; 1' ; 2 ; 3 ; 4 ; 4' ; 5 ; 6 comprend au moins une portion rectiligne, de section constante (portion 23 du guide 2, par exemple). Au niveau de cette portion, le guide a une largeur L.

Cette largeur correspond à l'extension de la zone intérieure du guide, selon l'axe transverse y. Il s'agit de la distance entre deux éléments de liaison, situés respectivement d'un côté et de l'autre du guide. Il s'agit plus précisément de la distance entre la surface latérale du premier élément de liaison 15 (ou 55, ou encore 65), et la surface latérale du deuxième élément de liaison 15 (ou 55, ou encore 65), comme illustré sur la figure 2 (en pratique, la largeur effective du guide, pour la propagation des ondes électromagnétiques, est légèrement plus grande que L).

Le guide 1 ; 1' ; 2 ; 3 ; 4 ; 4' ; 5 ; 6 est configuré ici pour guider des ondes ayant une fréquence f comprise entre 100 GHz et 2 THz.

Dans le cas des guides 1 ; 2 ; 3 ; 4 ; 4' ; 5 et 6, l'espace intérieur du guide, situé entre les première 11 ; 51 et deuxième 12 ; 52 plaques et entre les éléments de liaison 15 ; 55 ; 65, est occupé par un milieu diélectrique homogène ayant une permittivité relative εᵣ à la fréquence f. Ce milieu peut être de l'air, un polymère de remplissage (cas des guides 1 2 ; 3 ; 4 ; 4' et 6), ou de l'oxyde de silicium (cas du guide 5). Pour pouvoir guider une onde (de type TE10) de fréquence f, la largeur L mentionnée plus haut alors est choisie supérieure à λ/2, où λ=c/(f.(εᵣ)^{1/2}), c étant la vitesse des ondes électromagnétiques dans le vide. Plus précisément, la largeur L du guide peut être choisie de manière à ce que sa largeur effective L_{eff} soit supérieure à λ/2, où L_{eff} = L + d - d²/(0,95×p).

Dans le cas du guide 1', l'espace intérieur du guide, situé entre les première 11 et deuxième 12 plaques et entre les éléments de liaison 15, est occupé par une structure composite formée de plusieurs matériaux diélectriques différents (voir la figure 4). Dans ce cas, la largeur minimale du guide, permettant la propagation d'onde de fréquence f, pourra par exemple être déterminée par simulation numérique.

Dans le cas des guides 1 ; 1' ; 2 ; 3 ; 4 et 4', les micropiliers 15 ont un diamètre d, et sont disposés régulièrement, périodiquement le long du bord du guide, avec un pas p. Deux micropiliers successifs sont ainsi séparés (au niveau de leurs surfaces latérales - autrement formulé, au niveau de leurs surfaces externes) par un écart e=p-d. Le pas p est choisi de manière à ce que le taux d'occupation linéïque d/p (i.e. : la proportion de la bordure du guide occupée par les micropiliers) soit supérieur à 50%. Pour cela, le pas p est choisi inférieur au double du diamètre d des micropiliers. Cette disposition permet de diminuer les pertes à la propagation, dans le guide.

Le diamètre d des micropiliers est par exemple compris entre 10 et 50 microns, tandis que leur hauteur h (qui est aussi l'épaisseur de la zone intérieure au guide) est par exemple comprise entre 10 et 100 microns.

Dans le cas du guide 6 (figure 14), les éléments de liaison 65, qui regroupent chacun un couple de micropoteaux 651 et 652, sont répartis le long du guide 6 de la même manière que les micropoteaux 15 mentionné plus haut (taux d'occupation linéïque supérieur à 50% notamment). Le diamètre des micropoteaux 651, 652 est le même que le diamètre d mentionné plus haut, et ils ont chacun une hauteur comprise par exemple entre 5 et 30 microns.

Dans le cas du guide d'onde 5 (assemblage par « direct hybrid bonding »), la hauteur totale h' des éléments de liaison 55 (qui est aussi l'épaisseur de la zone intérieure au guide) est plus faible que dans le cas d'un assemblage par micropiliers. Elle est par exemple comprise entre 1 et 10 microns. Quant à la largeur ou au diamètre des vias 55a, 55b, il est compris par exemple entre 0,5 et 5 microns (tandis que le diamètre ou la largeur des éléments de raccordement 55c, 55d peut être compris par exemple entre 0,5 et 10 microns).

On pourra noter que, dans les cinq premiers modes de réalisation du guide 1 ; 2 ; 3 ; 4 ; 5 (et pour leurs variantes 1' et 4'), les éléments de liaison électrique qui délimitent latéralement le guide sont des éléments de contactage 15 ; 55 électriquement conducteurs, permettant chacun une conduction électrique de la première plaque 11 ; 51 à la deuxième plaque 11 ; 52 (en d'autres termes, ces éléments de liaison forment chacun un pont conducteur entre la première plaque et la deuxième plaque).

En revanche, dans le sixième mode de réalisation, les éléments de liaison électrique, 65, qui délimitent latéralement le guide 6 sont, des éléments qui, comme déjà indiqué, relient la première plaque 11 à la deuxième plaque 12 par une liaison capacitive, sans contact électrique direct.

On pourra noter que dans les différents modes de réalisation considérés ici, et quel que soit le mode d'assemblage considéré, chaque élément de liaison 15 ; 55 ; 65 est formé de deux parties (par exemple les micropoteaux 151 et 152, ou 651 et 652 ; ou l'ensemble 55a, 55c et l'ensemble 55b, 55d), l'un lié à la première puce et l'autre lié à la deuxième puce, et raccordées l'une à l'autre pour lier les deux puces.

### Guide d'onde selon le premier mode de réalisation

Comme mentionné plus haut, dans ce premier mode de réalisation, les lignes de micropiliers 13 et 14 qui bordent le guide, respectivement à droite et à gauche de celui-ci, sont rectilignes, et parallèles entre elles (figure 2).

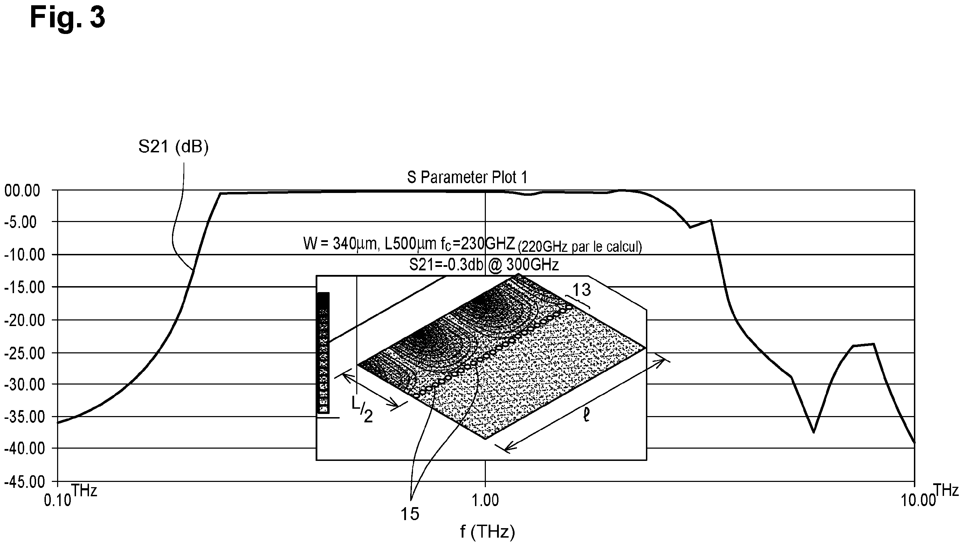

La figure 3 montre l'évolution d'un coefficient de transmission S21 du guide 1, exprimé en décibels (dB), en fonction de la fréquence f (exprimée en THz), dans un cas où le guide à une largeur L de 340 microns et une longueur l de 500 microns, l'espace intérieur du guide étant rempli par un matériau à base de polymères dont la permittivité relative εᵣ est égale à 4 environ. Pour cette simulation, les micropiliers ont chacun un diamètre d de 10 microns, une hauteur h de 20 microns et le pas p entre micropiliers est de 20 microns (taux d'occupation linéïque de 50%). Les résultats de la figure 3, obtenus par simulation numérique (en tenant compte notamment de l'absorption dans les éléments métalliques qui délimitent le guide), montrent que la fréquence de coupure fc du guide est égale à 230 GHz, et que le coefficient de transmission S21 est compris entre 0 et -0,5 dB sur une gamme de fréquence étendue. A 300 GHz par exemple, il vaut -0,3dB, soit -0,6dB/mm. Avec ce guide, les pertes à la propagation sont donc nettement plus faibles que pour un guide coplanaire ou pour un microstrip (pour lesquels le même coefficient de transmission serait plutôt de l'ordre de -3 dB/mm).

Sur la figure 3, une vue de détail du guide 1 est insérée dans la figure. Elle montre, en niveaux de gris, l'intensité du champ électrique associée à l'onde guidée, en différents points du guide, à une fréquence de 464 GHz.

Comme déjà indiqué, la figure 4 montre une variante 1' du guide de la figure 2. Le guide 1' est identique au guide 1 de la figure 2, si ce n'est que l'espace intérieur du guide est occupé par une structure composite formée de plusieurs matériaux diélectriques différents, au lieu d'être occupé par un milieu diélectrique homogène. Cette structure composite comprend ici trois couches 131, 132, 133, formées respectivement de trois matériaux diélectriques différents. Ces couches sont parallèles aux puces. Ces trois couches remplissent ici l'ensemble du volume intérieur du guide. En variante, d'autres structures composites sont envisageables, avec un nombre de couches différentes, ou avec des parties gravées, ou encore avec des inclusions d'un autre matériau diélectrique au sein de l'une des couches.

### Guide d'onde selon le deuxième mode de réalisation

Le guide 2 du deuxième mode de réalisation comprend une première partie 23 de section constante, qui se raccorde à une deuxième partie 24 évasée, jouant un rôle d'antenne cornet (figures 4 et 5).

Au niveau de la première partie 23, les lignes droite et gauche de micropiliers, 13 et 14, sont rectilignes et parallèles entre elles, et en l'occurrence, parallèle à l'axe x. Au niveau de la deuxième partie 24, évasée, qui s'élargit progressivement, les lignes de micropiliers droite et gauche, 25, 26 qui délimitent le guide 2, sont rectilignes, mais non-parallèles entre elles. Elles forment entre elle un angle compris par exemple entre 60 et 140 degrés, voire entre 60 et 120 degrés.

L'extrémité arrière de la première partie 23 du guide, qui est située à l'opposé de l'antenne, est fermée. Au niveau de cette extrémité, un ou plusieurs micropiliers 22 sont répartis sur la largeur du guide, entre les deux lignes 13 et 14, pour fermer la section du guide et empêcher les ondes guidées de sortir du guide par cette extrémité (en les réfléchissant vers l'antenne). En variante, à l'extrémité arrière du guide, au lieu de disposer les micropiliers en question pour fermer la section du guide, on pourrait les disposer de manière à former une cavité résonante au niveau de cette extrémité arrière. En variante encore, l'extrémité arrière du guide pourrait être ouverte (mais cette solution conduit en général à des performances moindres pour le guide ; dans un tel cas, la distance entre le micropoteau d'injection et la face arrière ouverte est de préférence choisie égale à un multiple de la λ_{g}/2, λ_{g} étant la longueur d'onde guidée dans le guide ; cette une distance peut donc, en particulier, être égale au double de celle employée dans le cas d'une extrémité arrière du guide fermée par une ligne de micropoteaux ou vias).

Les ondes électromagnétiques, qui sont guidées dans ce guide pour être émises ensuite par l'antenne, sont injectées dans le guide 2 au moyen d'un micropoteau conducteur 21, situé du côté de l'extrémité arrière de la première partie 23 du guide, entre les deux lignes 13 et 14. Ce micropoteau 21, qui fait saillie dans le guide 2, est raccordé électriquement à la première puce du microcircuit, ici. Ce micropoteau 21 peut aussi servir à extraire du guide des ondes reçues par l'antenne.

L'extrémité ouverte de la partie évasée 24 du guide (qui est son extrémité la plus large) est située ici à proximité d'un bord latéral libre de l'empilement de puces mentionné plus haut, voire directement au bord de cet empilement. L'ouverture de la partie évasée du guide est située par exemple au droit d'une face latérale libre de cet empilement (telle que le face 120 de la figure 1), pour que l'onde rayonnée par l'antenne puisse sortir librement du microcircuit.

Dans l'exemple de la figure 5, le guide d'onde 2 comporte deux parties 23 et 24 bien délimitées (dont une évasée), chacune à bords rectilignes. En notera toutefois, que, en variante, les lignes de micropiliers gauche et droite qui délimitent le guide pourraient être courbes, et s'évaser progressivement, de manière continue, le long du guide.

### Guide d'onde selon le troisième mode de réalisation

Le guide d'onde 3 de ce troisième mode de réalisation s'étend le long de l'axe x, depuis une première extrémité, fermée, jusqu'à une deuxième extrémité, fermée elle aussi (figure 6).

Au niveau de la première extrémité, un ou plusieurs micropiliers 22 sont répartis sur la largeur du guide (entre les deux lignes de micropiliers qui délimitent latéralement le guide), pour fermer la section du guide et empêcher les ondes guidées de sortir du guide par cette extrémité.

De même, au niveau de la deuxième extrémité, un ou plusieurs micropiliers 32 sont répartis sur la largeur du guide (entre les deux lignes de micropiliers qui délimitent latéralement le guide), pour fermer la section du guide et empêcher les ondes guidées de sortir du guide par cette deuxième extrémité.

Le guide 3 comprend, du côté de la première extrémité, un micropoteau 21 conducteur, raccordé électriquement à la première puce, et qui fait saillie dans le guide, entre les deux lignes de micropiliers qui délimitent latéralement le guide. Le guide 3 comprend aussi, du côté de la deuxième extrémité, un micropoteau 31 conducteur, raccordé électriquement à la deuxième puce, et qui fait saillie dans le guide, entre les deux lignes de micropiliers qui délimitent latéralement le guide. Ces deux micropoteaux 21 et 31 permettent chacun d'injecter dans le guide 3 et/ou d'extraire du guide 3 une onde électromagnétique.

Cet agencement permet notamment de transmettre un signal à très haute fréquence de la première puce à la deuxième puce. Le guide 3 rempli en outre une fonction de filtrage fréquentiel, ici. Il permet ainsi de transmettre un signal à très haute fréquence (de fréquence comprise typiquement entre 0,1 et 2 THz), de la première puce à la deuxième puce, ou inversement, en filtrant ce signal.

Cet effet de filtrage fréquentiel est obtenu ici par des changements de section du guide. Le guide comprend en effet une ou plusieurs portions (ici, deux portions 34 et 36) plus larges que le reste du guide.

En l'occurrence, le guide 3 comprend ici cinq portions 33, 34, 35, 36 et 37, situées les unes à la suite des autres, dans cet ordre. Les portions 33, 35 et 37 ont la même largeur L et ont une section constante. La portion 34 a une largeur L' supérieure à L (par exemple supérieure au double de L), et la portion 35 a une largeur L" elle aussi supérieure à L. La portion 33 est située à la première extrémité du guide 3, tandis que la portion 37 est située à sa deuxième extrémité. Les portions 34 et 36 forment chacune une cavité résonante, ces deux cavités étant couplées l'une à l'autre. Les dimensions de ces cavités (largeur, longueur) et de la portion de jonction 35 qui les relie peuvent être ajustées (par exemple par simulation numérique) de manière à obtenir la réponse passe-bande souhaitée. Pour rendre ce filtre passe-bande plus sélectif, on peut augmenter le nombre de cavités résonantes présente le long du guide.

On notera que, même si le guide 3 présente ces changements abrupts de section (i.e. : avec des discontinuités de section correspondant à un saut de largeur d'une portion du guide à l'autre), le guide 3 reste bordé par des micropiliers de chaque côté du guide, de manière continue, sans présenter d'ouverture large sur les côtés du guide (i.e. sans présenter d'ouverture plus large que le diamètre d des micropiliers).

On pourra noter que le micropoteau 21 est raccordé ici à la première puce (mais non à la deuxième) tandis que le micropoteau 31 est raccordé à la deuxième puce (mais non à la première). Mais en variante, ces deux micropoteaux pourraient toutefois se raccorder tous les deux à la même puce (par exemple la première puce), sans changement de puce pour le signal filtré par le guide.

### Guide d'onde selon le quatrième mode de réalisation

Comme dans le deuxième mode de réalisation, le guide d'onde 4 du quatrième mode de réalisation comprend une portion évasée, 45, jouant le rôle d'une antenne cornet. Il comprend aussi une portion rectiligne, 42, qui mène à cette portion évasée 45. Une fonction de filtrage fréquentiel est implémentée au niveau de la portion 42 (en l'occurrence, cette fonction est implémentée de manière légèrement différente du troisième mode de réalisation). L'onde électromagnétique guidée par le guide 4 est injectée dans celui-ci à une extrémité du guide opposée à l'antenne. Elle est injectée au moyen d'une piste 44 qui s'élargit progressivement pour finir par former la première plaque 11 du guide d'onde (au lieu d'être injectée grâce à un micropoteau faisant saillie dans le guide).

Comme on peut le voir sur les figures 9 et 10, une piste électrique 410 de type microruban, située du côté de la première puce, se raccorde à la piste 44, cette piste 44 s'élargissant ensuite progressivement jusqu'à avoir une largeur proche de la largeur L du guide. La piste 44 se raccorde alors à l'entrée du guide 4, à l'extrémité du guide située à l'opposé de l'antenne. La piste 44 se raccorde plus précisément à la première plaque 11 du guide (plaque inférieure du guide). Ici, la piste 410, la piste 44 et la première plaque 11 sont d'un seul tenant (gravées dans un même plan métallique).

Au niveau de la portion 42 du guide, les lignes de micropiliers 13 et 14 qui bordent le guide, respectivement du côté droit et du côté gauche, sont rectilignes et parallèles entre elles (la section du guide est donc constante, contrairement au guide du troisième mode de réalisation). La fonction de filtrage mentionnée plus haut est alors obtenue grâce à des micropiliers supplémentaires 15', répartis à l'intérieur du guide de manière à former une ou plusieurs barrières s'étendant transversalement par au guide pour créer un ou plusieurs étranglements.

Le guide 4 comprend ainsi une courte ligne de micropiliers supplémentaires, 43, qui s'étend, vers l'intérieur du guide, à partir de la ligne de micropiliers 13 qui délimite le bord droit du guide. Elle comprend aussi une autre ligne de micropiliers supplémentaires, 43', qui s'étend, vers l'intérieur du guide, à partir de la ligne de micropiliers 14. Les deux lignes 43 et 43' sont situées en face l'une de l'autre, et délimitent un étranglement au milieu de la section du guide.

Le guide 4 comprend un autre couple de lignes de micropiliers, 44 et 44', qui s'étendent transversalement par rapport au guide, à l'intérieur de celui-ci. Ces deux lignes 44 et 44' délimitent un étranglement qui est moins étroit que pour les lignes 43 et 43', et qui est situé en amont des lignes 43 et 43'. Le guide 4 comprend encore un autre couple de lignes de micropiliers, 46 et 46', qui s'étendent transversalement par rapport au guide, à l'intérieur de celui-ci, et qui sont situées en aval des lignes 43 et 43'. Les deux lignes transverses 46 et 46' sont symétriques des lignes 44 et 44' par rapport au lignes 43 et 43'. Le guide 4 peut comprendre encore d'autres couples de lignes transverses situées en amont et/ou en aval des lignes 43, 43', avec, le long du guide une rétrécissement progressif (d'un couple de ligne à l'autre), puis un élargissement progressif des étranglements en question. Ce type d'agencement permet différentes fonctions de filtrage : passe-bas, passe-haut, passe-bande ou coupe-bande. On notera toutefois qu'un filtrage de type passe-bas pur, puisqu'un tel guide ne permet de transmettre une onde de fréquence inférieure à la fréquence de coupure basse du guide d'onde lui-même.

Pour ce qui est de la partie évasée 45, elle est identique, ou tout au moins similaire à la partie évasée 24 du guide 2 du deuxième mode de réalisation.

Comme déjà indiqué, les figures 11 et 12 montrent une variante 4' du guide 4 de la figure 9. Le guide 4' est identique au guide 4 de la figure 9, si ce n'est que les lignes de micropiliers supplémentaires 15' (qui forment, localement, des rétrécissements de section) sont remplacées par des lignes de micropoteaux 151' internes au guide. Dans le cadre de cette variante, pour réduire localement la section du guide :
- au lieu d'employer des micropiliers 15' qui s'étendent chacun sur toute la hauteur h du guide, mais qui sont répartis sur une partie seulement de la largeur L du guide (pour laisser un passage pour les ondes),
- on emploie des micropoteaux 151' qui s'étendent chacun sur une partie seulement de la hauteur h du guide, mais qui sont par contre répartis sur toute la largeur L du guide.

Le guide 4' comprend ainsi plusieurs lignes 43", 44", 46" de micropoteaux 151', qui s'étendent chacune transversalement par rapport au guide 4', à l'intérieur du guide. Chaque micropoteau 151' s'étend à partir de la première ou de la deuxième plaque 11, 12 (ici à parti de la première), en direction de l'autre plaque. Chaque micropoteau 151' a une hauteur hₘ inférieure à la hauteur (interne) h du guide, par exemple inférieure aux deux tiers ou même à la moitié de cette hauteur h.

Dans d'autres variantes, on pourrait employer des micropoteaux qui s'étendent chacun sur une partie seulement de la hauteur du guide, et qui soient répartis sur une partie seulement de la largeur du guide.

### Guide d'onde selon le cinquième mode de réalisation

Comme indiqué plus haut, le guide 5 du cinquième mode de réalisation est réalisé entre deux puces assemblées l'une à l'autre par « liaison hybride directe », au lieu d'être assemblées au moyen de micropiliers. La hauteur h' du guide est donc plus petite que pour les quatre modes de réalisation précédents.

Dans ce cinquième mode de réalisation, les éléments de contactage 55 peuvent être agencés le long du guide 5 de manière identique, ou tout au moins comparable aux micropiliers des modes de réalisation un à quatre. En particulier, ils peuvent être répartis de manière à former une antenne cornet, ou de manière à obtenir des étranglements ou changements de section afin de réaliser un filtrage fréquentiel des ondes guidées.

### Guide d'onde selon le sixième mode de réalisation

Le guide d'onde 6 selon le sixième mode de réalisation est identique, ou tout au moins similaire au guide d'onde 1 du premier mode de réalisation, si ce n'est que, pour chaque couple de micropoteaux situés en face l'un de l'autre, les deux micropoteaux en question, 651 et 652 ne sont pas en contact électrique l'un avec l'autre (au lieu de se raccorder l'un à l'autre pour former un micropilier conducteur). Leurs faces d'extrémités respectives 653 et 654 sont séparées l'une de l'autre pas un isolant électrique. Elles sont séparées l'une de l'autre par une distance e_{z} petite mais non nulle.

Les éléments de liaison 65, qui délimitent le guide 6 latéralement, de part et d'autre de celui-ci, sont ainsi formé chacun de deux micropoteaux 651, 652 espacés l'un de l'autre. Pour chaque couple, le premier micropoteau 651 s'étend à partir de la première plaque 11, jusqu'à sa face d'extrémité 653. Ce premier micropoteau 651 s'étend perpendiculairement à la première plaque, et est en contact électrique avec elle. Le deuxième micropoteau 652 s'étend à partir de la deuxième plaque 12, jusqu'à sa face d'extrémité 654. Il s'étend perpendiculairement à la deuxième plaque, et est en contact électrique avec elle. Les premier et deuxième micropoteaux sont situés en face l'un de l'autre, mais pas nécessairement parfaitement. Comme on peut le voir sur la figure 14, un léger désalignement (par exemple inférieur à un tiers du diamètre d des micropoteaux) entre les micropoteaux 651 et les micropoteaux 652 peut être présent (ce désalignement étant dû par exemple à une erreur d'alignement lors de l'assemblage des puces).

Pour chaque élément de liaison 65, l'écart e_{z} entre les deux faces d'extrémité 653 et 654 des deux micropoteaux est par exemple inférieur à 2 microns, voir inférieur à 1 micron ou même à 0,5 micron. Cela permet d'établir une liaison capacitive pour laquelle la capacité de jonction est assez élevée.

Dans ce sixième mode de réalisation, les éléments de liaison 65 peuvent être agencés le long du guide 6 de manière identique, ou tout au moins comparable aux micropiliers des modes de réalisation un à quatre. En particulier, ils peuvent être répartis de manière à former une antenne cornet, ou de manière à obtenir des étranglements ou changements de section afin de réaliser un filtrage fréquentiel des ondes guidées

Par ailleurs, les éléments de liaison eux-mêmes peuvent être réalisés différemment. Par exemple, chaque élément de liaison pourrait comprendre un seul micropoteau (au lieu de deux), en contact avec la première plaque, et qui s'étende presque jusqu'à la deuxième plaque, sa face d'extrémité étant séparé de la deuxième plaque par la distance e_{z} en question. En variante encore, le guide pourrait être délimité, le long de chaque bord, par une ligne de micropoteaux, avec une alternance entre :
- un micropoteau raccordé à la première plaque, et s'étendant presque jusqu'à la deuxième plaque, mais sans contact électrique avec celle-ci (avec un écart e_{z}), puis
- un micropoteau raccordé à la deuxième plaque, et s'étendant presque jusqu'à la première plaque, mais sans contact avec celle-ci (avec un écart ez),
- et ainsi de suite.

Différentes variantes peuvent être apportées au guide d'onde qui vient d'être présenté, en plus de celles déjà mentionnées. Ainsi, dans un plan parallèle aux puces, le guide pourrait avoir une forme générale de Y afin de mélanger deux signaux à très haute fréquence (injectés chacun au niveau de l'une des branches du Y), ou au contraire pour réaliser un séparateur (diviseur) de signaux. Il pourrait aussi avoir une forme générale en X, avec deux entrées (une par branche) et deux sorties (là aussi, une par branche). Le guide pourrait aussi s'étendre le long d'une ligne moyenne courbe, en faisant un virage.

Par ailleurs, les éléments de liaison pourraient être des microbilles, chaque microbille étant en contact, d'une part avec la première plaque, et d'autre part avec la deuxième plaque. De tels microbilles peuvent par exemple avoir un diamètre compris entre 20 microns et 200 microns, et être agencées avec un pas p égal au double de leur diamètre. Des microbilles spécifiques de petit diamètre (diamètre compris par exemple entre 1 et 5 microns), par exemple à base d'Indium, peuvent aussi être employées pour délimiter latéralement le guide.

## Revendications

1. Microcircuit (100 ; 500) intégrant un guide (1 ; 1' ; 2 ; 3 ; 4 ; 4' ; 5 ; 6) d'onde à section rectangulaire, **caractérisé en ce qu'**il comprend une première puce (101 ; 501) et une deuxième puce (102 ; 502) assemblées l'une sur l'autre, le guide (1 ; 1' ; 2 ; 3 ; 4 ; 4' ; 5 ; 6) d'onde étant situé dans une zone de jonction (103 ; 503) entre puces et s'étendant parallèlement aux puces, le guide d'onde comprenant une première plaque (11 ; 51) conductrice, située du côté de la première puce (101 ; 501) et parallèle à la première puce, ainsi qu'une deuxième plaque (12 ; 52) conductrice, située du côté de la deuxième puce (102 ; 502) et parallèle à la deuxième puce, le guide (1 ; 1' ; 2 ; 3 ; 4 ; 4' ; 5 ; 6) d'onde étant délimité latéralement, d'un côté et de l'autre du guide, par un ou des éléments de liaison (15 ; 55 ; 65) électrique, reliant électriquement la première puce à la deuxième puce.

2. Microcircuit (100) selon la revendication 1, dans lequel les éléments de liaison comprennent des micropoteaux (151, 152 ; 651, 652), ou des micropiliers (15), ou des microbilles disposés en ligne (13, 14) les uns à la suite des autres, le long du côté considéré du guide (1 ; 1' ; 2 ; 3 ; 4 ; 4' ; 6) d'onde.

3. Microcircuit (100) selon la revendication 2, dans lequel lesdits micropoteaux (151, 152 ; 161, 162), ou micropiliers (15) ou microbilles sont répartis le long du côté considéré du guide (1 ; 1' ; 2 ; 3 ; 4 ; 4' ; 6) d'onde avec un taux d'occupation linéïque supérieur à 50%.

4. Microcircuit (500) selon la revendication 2, dans lequel
- la première plaque (51) est recouverte d'une première couche (506) électriquement isolante traversée par des premiers vias (55a) conducteurs,
- la deuxième plaque (52) est recouverte d'une deuxième couche (507) électriquement isolante traversée par des deuxièmes vias (55b) conducteurs,
- la deuxième couche (507) est en contact avec la première couche (506) et adhère à la première couche, les deuxièmes vias (55b) étant en contact avec les premiers vias (55a), directement ou par l'intermédiaire d'éléments de raccordement (55c, 55d), et dans lequel
- chaque élément de liaison (55) comprend l'un des premiers vias (55a), ainsi que le deuxième via (55b) correspondant avec lequel il est en contact.

5. Microcircuit (100; 500) selon l'une des revendications précédentes, dans lequel au moins certains desdits éléments de liaison sont des éléments de contactage (15 ; 55) électriquement conducteur, permettant chacun une conduction électrique de la première plaque (11 ; 51) à la deuxième plaque (12 ; 52).

6. Microcircuit selon l'une des revendications 1 à 3, dans lequel au moins l'un desdits éléments de liaison (65) comprend un micropoteau (651) électriquement conducteur qui s'étend à partir de la première plaque (11) en direction de la deuxième plaque (12), et qui est espacé de la deuxième plaque, (12) pour relier la première plaque à la deuxième plaque par une liaison capacitive.

7. Microcircuit selon la revendication précédente, dans lequel ledit élément de liaison (65), qui relie la première plaque (11) à la deuxième plaque (12) par une liaison capacitive, comprend un micropoteau supplémentaire (652) électriquement conducteur, qui s'étend à partir de la deuxième plaque (12) en direction de la première plaque (11), jusqu'à une face d'extrémité (654) du micropoteau supplémentaire (652),la face d'extrémité (654) du micropoteau supplémentaire (652) étant située en vis-à-vis et à distance réduite (ez) d'une face d'extrémité (653) dudit micropoteau (651).

8. Microcircuit (100 ; 500) selon l'une des revendications précédentes, dans lequel le guide (1 ; 1' ; 2 ; 3 ; 4 ; 4' ; 5 ; 6) d'onde est dimensionné pour guider une onde électromagnétique ayant une fréquence f supérieure ou égale à 100 GHz.

9. Microcircuit (100 ; 500) selon la revendication précédente, dans lequel l'espace intérieur du guide (1 ; 2 ; 3 ; 4 ; 4' ; 5 ; 6), situé entre les première (11 ; 51) et deuxième (12 ; 52) plaques et entre lesdits éléments de liaison (15 ; 55 ; 65), est occupé par un milieu diélectrique ayant une permittivité relative εᵣ à la fréquence f, et dans lequel le guide (1 ; 2 ; 3 ; 4 ; 4' ; 5 ; 6) d'onde a une section dont la largeur (L), selon une direction (y) parallèle aux puces, est supérieure à λ/2, où λ=c/(f.(εᵣ)^{1/2}), c étant la vitesse des ondes électromagnétiques dans le vide.

10. Microcircuit (100) selon l'une des revendications 1 à 8, dans lequel l'espace intérieur du guide (1'), situé entre les première (11) et deuxième (12) plaques et entre lesdits éléments de liaison (15), est occupé par une structure composite formée de plusieurs matériaux diélectriques différents.

11. Microcircuit (100 ; 500) selon l'une des revendications précédentes, dans lequel l'une au moins des première (101 ; 501) et deuxième (102 ; 502) puces intègre un ou plusieurs composants de type transistor, diode ou amplificateur, configuré pour générer, amplifier ou filtrer un signal électrique de fréquence supérieure ou égale à 100 GHz.

12. Microcircuit (100) selon l'une des revendications précédentes, dans lequel une extrémité du guide (2 ; 4 ; 4') est ouverte et dans lequel une partie (24 ; 45) au moins du guide, qui débouche par cette ouverture, est évasée et s'élargit en direction de ladite ouverture.

13. Microcircuit (100) selon l'une des revendications précédentes, dans lequel le guide (3) présente un ou plusieurs changements de section abrupts.

14. Microcircuit (100) selon l'une des revendications précédentes, dans lequel le guide (4) d'onde comprend une ou plusieurs lignes (43, 43', 44, 44', 46, 46') d'éléments de liaison supplémentaires (15'), qui s'étendent chacune transversalement par rapport au guide (4), à l'intérieur du guide, pour former un ou plusieurs étranglements dans le guide.

15. Microcircuit (100) selon l'une des revendications précédentes, dans lequel le guide (4') d'onde comprend un ou plusieurs micropoteaux internes (151'), situés chacun à l'intérieur du guide, chaque micropoteau interne (151') s'étendant à partir de la première plaque (11), en direction de la deuxième plaque (12), et ayant une hauteur (hₘ) inférieure à un écart (h) qui sépare la première plaque (11) de la deuxième plaque (12), par exemple inférieure aux deux tiers dudit écart (h).
